# FASCICULE DE BREVET EUROPEEN

(11) **EP 1 977 258 B1**
(45) Date de publication et mention de la délivrance du brevet: **11.05.2011**
(21) Numéro de dépôt: 07730821.1
(22) Date de dépôt: 11.01.2007
(51) Int. Cl.: G01R 15/20, G01R 33/07, G01R 33/09, G01R 1/07

(54) **DISPOSITIF DE MESURE DE COURANT CONTINU A FORTE DYNAMIQUE DE MESURE, ENSEMBLE ELECTROTECHNIQUE COMPORTANT UN TEL DISPOSITIF DE MESURE ET DISPOSITIF DE COUPURE AYANT UN TEL ENSEMBLE ELECTROTECHNIQUE**
VERFAHREN ZUR GLEICHSTROMMESSUNG MIT GROSSER MESSUNGSSCHWANKUNG, ELEKTRONISCHE ANORDNUNG MIT EINER SOLCHEN MESSVORRICHTUNG UND VORRICHTUNG ZUR STROMABSCHALTUNG MIT EINER SOLCHEN ANORDNUNG
DEVICE FOR MEASURING DC CURRENT HAVING LARGE MEASUREMENT VARIATION, ELECTRONIC ASSEMBLY COMPRISING SUCH A MEASUREMENT DEVICE AND CIRCUIT BREAKER HAVING SUCH AN ASSEMBLY

(30) Priorité: 24.01.2006 FR 0600658
(43) Date de publication de la demande: 08.10.2008
(73) Titulaire: Schneider Electric Industries SAS, 92500 Rueil-Malmaison (FR)
(72) Inventeur: SERPINET, Marc, F-38220 Montchaboud (FR); VINCENT, François, F-38500 La Buisse (FR)
(74) Mandataire: Tripodi, Paul
(86) Numéro de dépôt international: PCT/FR2007/000045
(87) Numéro de publication internationale: WO 2007/085711

(56) Documents cités:
- EP-A1- 1 030 183
- DE-A1- 10 045 670
- DE-A1- 10 108 640
- DE-A1- 10 228 764
- DE-A1- 10 240 242
- US-A- 4 518 918
- US-A- 4 625 166

## Description

### DOMAINE TECHNIQUE DE L'INVENTION

L'invention est relative à un dispositif de mesure de courant continu comportant au moins un premier capteur magnétique et au moins un second capteur magnétique, lesdits capteurs magnétiques étant sensibles à un champ magnétique généré par un courant électrique circulant dans un conducteur. Le dispositif de mesure de courant comporte une unité de traitement connectée aux capteurs magnétiques et destinée à générer un signal de sortie dépendant des signaux de mesure fournis par les capteurs magnétiques et représentatif dudit courant électrique circulant dans le conducteur.

L'invention concerne aussi un ensemble électrotechnique comportant comprenant une carte de conversion reliée à des moyens de déclenchement destinés à envoyer des ordres de déclenchement. Enfin l'invention concerne aussi un dispositif de coupure comportant un mécanisme de d'ouverture de contacts électriques et un relais de commande relié à un ensemble électrotechnique selon l'invention.

### ETAT DE LA TECHNIQUE

L'utilisation de dispositif de mesure de courant continu est largement répandue notamment pour des applications navales ou nautiques.

Comme décrit dans les brevets US4625166, EP1030183, les dispositifs de mesure de courant continu utilisent des capteurs magnétiques. Ces capteurs magnétiques sont généralement des sondes à effet hall ou des magnétorésistances. Les capteurs magnétiques sont répartis géométriquement autour d'un conducteur dans lequel circule un courant électrique. Les capteurs magnétiques sont sensibles au champ magnétique induit par le courant électrique circulant dans le conducteur. Les capteurs détectent un champ magnétique proportionnel à l'intensité du courant électrique et émettent un signal électrique proportionnel au courant qui traverse le capteur.

Les capteurs magnétiques sont généralement associés à des moyens de traitement. Lesdits moyens de traitement fournissent une information représentative de la valeur du courant électrique circulant dans le conducteur. En outre, les moyens de traitement peuvent préalablement affecter un coefficient de pondération des signaux émis par chacun des capteurs magnétiques. Le coefficient de pondération peut être notamment dépendant de la position relative de chaque capteur magnétique par rapport au conducteur. Les moyens de traitement peuvent aussi établir la somme des signaux émis par tous les capteurs magnétiques.

Les sondes à effet hall peuvent être intégrées dans une structure magnétique placée autour d'un conducteur parcouru par un courant électrique continu. Le courant électrique induit un champ magnétique et on observe une circulation d'un flux magnétique dans la structure magnétique. Les sondes à effet hall traversées par le flux magnétique produisent alors un signal représentatif du champ magnétique observé de leur position par rapport au conducteur.

L'agencement des capteurs magnétiques avec la structure magnétique, permet généralement d'observer une bonne sensibilité pour de faibles courants électriques. La structure magnétique est généralement réalisée en matériau ferromagnétique comportant une perméabilité magnétique élevée. Compte tenu de la forte perméabilité magnétique de ladite structure magnétique, des flux magnétiques de faible intensité peuvent y circuler. L'intensité du signal émis par les capteurs magnétiques varie alors linéairement en fonction de l'intensité du courant électrique circulant dans le conducteur. La variation de l'intensité suit le profil d'une droite dont le coefficient directeur est dépendant du coefficient de perméabilité. Plus le coefficient de perméabilité est élevé, plus le coefficient directeur de la droite est important.

Cependant, lorsque les courants électriques dépassent une certaine intensité, la réponse du dispositif de mesure ne suit plus la courbe de réponse linéaire précédente. Suite à des phénomènes de saturation observés notamment dans la structure magnétique et/ou dans le capteur magnétique et/ou dans la chaîne de mesure, la réponse du dispositif de mesure est faussée. Par exemple, au-delà d'un flux maximum induit, une structure ferromagnétique peut commencer à saturer.

La circulation de forts courants électriques, notamment des courants de court-circuit, saturent ainsi le dispositif de mesure. Les signaux envoyés respectivement par les capteurs magnétiques ne sont plus proportionnels à l'intensité du courant circulant dans le conducteur et le signal fourni par le dispositif de mesure est erroné. Les courants électriques de forte intensité ne peuvent pas être mesurés avec ce type de dispositif de mesure. Notons que plus la perméabilité d'un matériau est forte, plus le niveau de saturation est atteint rapidement.

Les problèmes liés à la saturation ou à l'échauffement de la structure magnétique sont résolus dans le document de l'état de la technique EP1030183. En effet, les sondes à effet hall sont disposées sur une structure non magnétique. Cependant, ce type de solution présente l'inconvénient d'être peu sensible aux courants électriques de faible intensité. Dans ce type de capteur, le champ magnétique mesuré par les capteurs magnétiques est faible puisque les dits capteurs ne comportent pas de circuit magnétique.
Le document DE 100 45 670 A1 décrit un dispositif de mesure de courant continu comportant au moins deux capteurs magnétiques et une unité de traitement destinée à générer un signal de sortie comportant au moins deux entrées et des moyens de sélection fournissant ce signal de sortie et dépendant des premiers ou deuxièmes signaux de mesure. Le document DE 101 08 640 A1 décrit également un tel dispositif.

### EXPOSE DE L'INVENTION

L'invention vise donc à remédier aux inconvénients de l'état de la technique, de manière à proposer un dispositif de mesure de courant continu sensible et à forte dynamique de mesure.

Le dispositif de mesure de courant continu selon l'invention est défini à la revendication 1.

L'ensemble électrotechnique comprenant un dispositif de mesure tel que défini ci-dessus est décrit à la revendication 13.

Le dispositif de coupure comprenant un ensemble électrotechnique que défini ci-dessus est décrit à la revendication 14.

### BREVE DESCRIPTION DES FIGURES

D'autres avantages et caractéristiques ressortiront plus clairement de la description qui va suivre de modes particuliers de réalisation de l'invention, donnés à titre d'exemples non limitatifs, et représentés aux dessins annexés sur lesquels :

la figure 1 représente une vue schématique d'un dispositif de mesure de courant continu selon un premier mode de réalisation de l'invention ;

la figure 2 représente une vue schématique d'un dispositif de mesure de courant continu selon un second mode de réalisation de l'invention ;

les figures 3 et 4 représentent des vues schématiques de l'agencement des capteurs magnétiques des dispositifs de mesure de courant continu selon les figures 1 et 2 ;

la figure 5 représente une vue schématique d'un dispositif de mesure de courant continu selon un troisième mode de réalisation du dispositif de mesure de courant ;

les figures 6 et 7 représentent des vues schématiques de l'agencement des capteurs magnétiques de la variante de réalisation selon la figures 6 ;

la figure 8 représente deux courbes des signaux émis par des capteurs magnétiques selon les figures 1 et 2 ;

la figure 9 représente deux courbes des signaux émis par des capteurs magnétiques selon la figure 5 ;

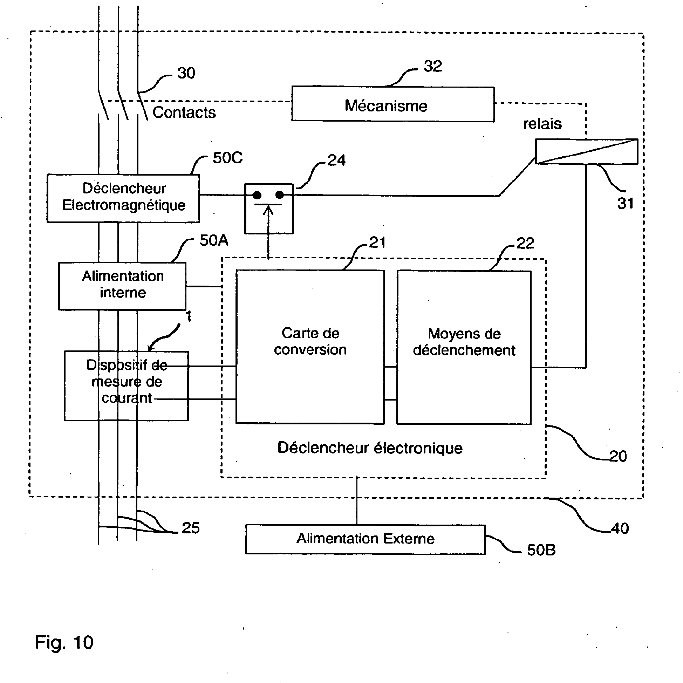

la figure 10 représente un schéma bloc général d'un dispositif de coupure selon un mode de réalisation de l'invention.

### DESCRIPTION DETAILLEE D'UN MODE DE REALISATION

Selon un premier mode de réalisation de l'invention, le dispositif de mesure de courant continu 1 comporte des capteurs magnétiques 4A, 4B sensibles à un champ magnétique généré par un courant électrique I circulant dans un conducteur 3. Ces capteurs magnétiques sont de préférence des sondes à effet Hall. On peut cependant envisager d'utiliser des magnétorésistances.

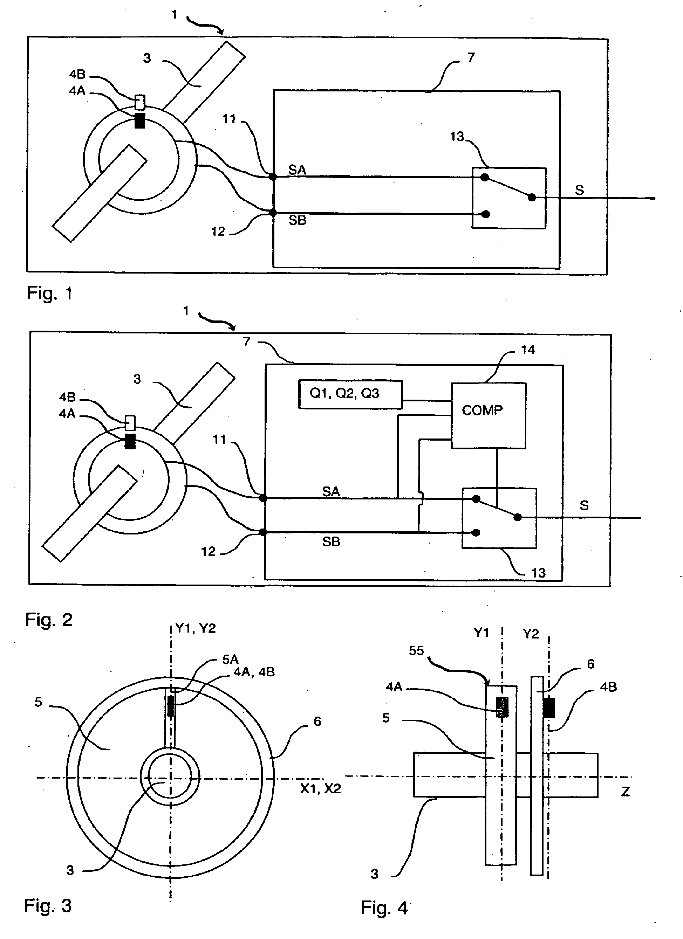

Comme représenté sur les figures 3 et 4, ces capteurs magnétiques sont répartis sur deux profils 55, 6.

Au moins un premier capteur magnétique 4A est intégré dans un premier profil magnétique 55 destiné à entourer un conducteur électrique 3. Le premier profil magnétique comprend au moins un tronçon 5 allongé réalisé dans un matériau ferromagnétique à forte perméabilité magnétique. Le tronçon est configuré de manière que ces deux extrémités soient placées en vis à vis. Un espace est présent entre ces deux extrémités. Cet espace forme un entrefer 5A dans lequel est placé un capteur magnétique 4A. Selon ce mode de réalisation, le premier capteur magnétique 4A est disposé dans un premier plan X1Y1. Le premier capteur magnétique 4A est sensible au champ magnétique créé par le passage du courant électrique I circulant dans le conducteur 3. Ledit capteur est destiné à fournir un premier signal de mesure SA continu représentatif du champ magnétique. La valeur efficace du premier signal de mesure SA dépend du champ magnétique reçu par le premier capteur magnétique 4A. Compte tenu que le champ magnétique est dépendant du courant électrique continu circulant dans le conducteur 3, ladite valeur efficace est ainsi proportionnelle audit courant continu.

Au moins un second capteur magnétique 4B est disposé sur au moins un tronçon 6 à faible perméabilité magnétique. Ce tronçon 6 tient essentiellement un rôle de support mécanique du ou des seconds capteurs 4B et forme un second profil destiné à entourer le conducteur électrique 3. Selon cet exemple de réalisation, on peut considérer que le tronçon 6 a une perméabilité magnétique sensiblement égale à celle de l'air. Selon ce mode de réalisation de l'invention, le second capteur magnétique 4B est disposé dans un second plan X2Y2. Le second capteur magnétique 4B est sensible au champ magnétique créé par le passage du courant électrique I circulant dans le conducteur 3. Ledit capteur est destiné à fournir un second signal de mesure SB représentatif du champ magnétique. La valeur efficace du second signal de mesure SB dépend du champ magnétique reçu par le capteur. Compte tenu que le champ magnétique est dépendant du courant électrique continu circulant dans le conducteur 3, ladite valeur efficace est ainsi proportionnelle audit courant continu.

Selon ce mode de réalisation, les premier et second capteurs magnétiques 4A, 4B sont placés à égale distance de l'axe central Z du conducteur 3. Les premier et second plans X1Y1 et X2Y2 sont décalés selon l'axe Z.

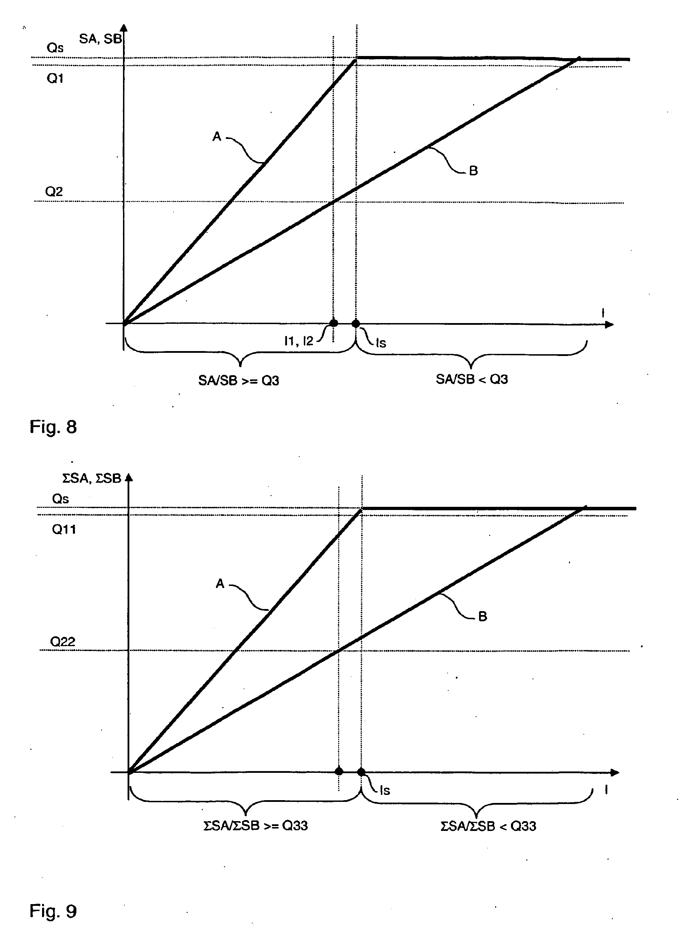

La figure 8 représente une première et une seconde courbe A et B des premier et second signaux de mesure SA et SB émis respectivement par les premier et second capteurs magnétiques 4A, 4B. Le premier profil magnétique 55 utilisé dans ce type de dispositif de mesure 1 comporte un seuil de saturation Qs. Le seuil de saturation Qs est à la fois dépendant des caractéristiques physiques et géométriques du premier profil magnétique 55 ainsi que d'un courant électrique Is dit de saturation. Le courant de saturation Is correspond au courant électrique à partir duquel le premier signal de mesure SA émis par le premier capteur magnétique 4A ne suit plus une courbe de réponse linéaire. La forme et la section du ou des tronçons 5 ainsi que la nature des matériaux utilisés pour la réalisation desdits tronçons 5 permettent de déterminer la perméabilité magnétique du premier profil magnétique 55.

Comme cela est représenté sur les figures 1 et 2, le dispositif de mesure 1 comporte une unité de traitement 7 connectée respectivement aux capteurs magnétiques 4A, 4B par une première et une seconde entrée 11, 12. L'unité de traitement 7 est destinée à générer un signal de sortie S représentatif du courant électrique I circulant dans le conducteur 3.

Après avoir reçu respectivement les premier et second signaux de mesure SA et SB des premier et second capteurs magnétiques 4A, 4B, des moyens de sélection 13 de l'unité de traitement 7 génèrent le signal de sortie S qui est dépendant d'une part de la valeur du premier signal de mesure SA pour des faibles courants électriques I et d'autre part de la valeur du second signal de mesure SB pour des forts courants électriques I.

Selon ce mode de réalisation de l'invention, les courants électriques I sont considérés comme faibles lorsque leurs valeurs sont inférieures à celle du courant de saturation Is saturant le premier profil magnétique 55. En outre, pour ce type de dispositif de mesure de courant, les courants électriques sont considérés comme forts lorsque leurs valeurs sont supérieures à celle du courant de saturation is saturant le premier profil magnétique 55.

Compte tenu de la forte perméabilité magnétique du premier profil magnétique 55, on observe une amplification et une bonne répartition du flux magnétique dans la sonde à effet Hall. Le flux magnétique induit par des courants électriques de faible intensité peut alors être détecté par le premier capteur magnétique 4A. La sensibilité du premier capteur magnétique 4A est donc suffisante pour des courants électriques faibles.

En présence de courants électriques I de forte intensité, le premier signal de mesure SA émis par le premier capteur 4A n'est plus exploitable. En effet, le premier profil magnétique 55 et/ou le premier capteur magnétique 4A et/ou la l'unité de traitement 7 sont saturés et le premier signal de mesure SA n'est alors plus proportionnel au courant électrique I circulant dans le conducteur 3.

Comme cela est représenté sur la figure 8, le tronçon 6 de faible perméabilité magnétique et le second capteur magnétique 4B ne sont pas encore soumis à des phénomènes de saturation dus à la présence de forts courants électriques. Ainsi le second capteur magnétique 4B peut encore fournir un second signal de mesure SB directement proportionnel aux courants électriques quelle que soit leur intensité.

Grâce à la combinaison des informations issues des premier et second ° capteurs magnétiques 4A, 4B, le dispositif de mesure 1 comporte ainsi une grande dynamique de mesure tout en gardant une bonne sensibilité pour la mesure de courant électrique de faible intensité.

Selon un mode de développement de l'invention représenté sur la figure 2, l'unité de traitement 7 du dispositif de mesure de courant continu 1 comporte des moyens de comparaison 14. Ces moyens de comparaison 14 comparent au moins un des signaux de mesure SA, SB avec au moins une consigne Q1, Q2, Q3.

Le signal de sortie S est dépendant du premier signal de mesure SA si le premier signal de mesure SA est inférieur à une première consigne Q1 et/ou si le second signal de mesure SB est inférieur à une seconde consigne Q2.

Selon ce mode de développement, la première consigne Q1 est inférieure au seuil de saturation Qs. Autrement dit, un premier courant électrique I1 donnant naissance à un premier signal de mesure SA égal à la première consigne Q1 est inférieur au courant de saturation Is. En outre, comme représenté sur la figure 9, un courant électrique I2 donnant naissance à un second signal de mesure SB égal à la seconde consigne Q2 est de préférence égal au premier courant I1.

En outre, les moyens de comparaison 14 effectuent une comparaison entre les premier et second signaux de mesure SA, SB et une troisième consigne Q3. La troisième consigne Q3 est égale, pour de faibles courants électriques I, à un rapport théorique entre le premier signal de mesure SA et le second signal de mesure SB. Le signal de sortie S étant dépendant du premier signal de mesure SA, si le rapport SA/SB mesuré entre le premier signal de mesure SA et le second signal de mesure SB est supérieur ou égal à la troisième consigne Q3.

Le procédé de mesure d'un courant électrique I avec un dispositif de mesure 1 selon les modes de réalisation préférentiels est le suivant.

Les premier et second signaux de mesure SA et SB sont comparés respectivement aux première et seconde consignes Q1 et Q2. En outre, le rapport SA/SB entre le premier signal de mesure SA et le second signal de mesure SB est comparé à la troisième consigne Q3. Les moyens de sélection 13 génèrent un signal de sortie S représentatif du courant électrique circulant le conducteur 3.

Ledit signa) de sortie est dépendant du premier signal de mesure SA lorsque :
- le premier signal de mesure SA est inférieur à une première consigne Q1 et/ou
- le second signal de mesure SB est inférieur à une seconde consigne Q2, et/ou
- le rapport SA/SB entre le premier signal de mesure SA et le second signal de mesure SB est supérieur ou égal à la troisième consigne Q3. Ledit rapport SA/SB est sensiblement constant pour des valeurs de courants électriques inférieurs au courant de saturation Is,

Ledit signal de sortie S est dépendant du second signal de mesure SB lorsque :
- le premier signal de mesure SA est supérieur à une première consigne Q1
   et/ou
- le second signal de mesure SB est supérieur à une seconde consigne Q2.
   et/ou
- le rapport SA/SB entre le premier signal de mesure SA et le second signal de mesure SB est inférieur à la troisième consigne Q3. Ledit rapport SA/SB tend à décroître pour des valeurs de courants électriques supérieurs au courant de saturation Is.

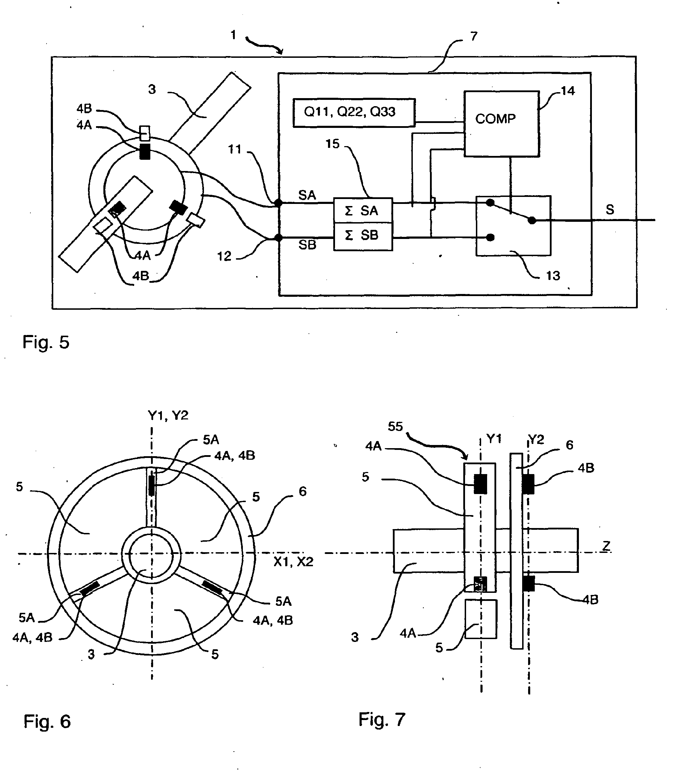

Selon un autre mode de réalisation de l'invention, le dispositif de mesure comprend au moins trois premiers capteurs magnétiques 4A et au moins trois seconds capteurs magnétiques 4B. Comme représenté sur les figures 6 et 7, les premiers et seconds capteurs magnétiques sont répartis en deux groupes. Selon ce mode de réalisation, trois premiers capteurs magnétiques 4A sont reliés entre eux par des premiers tronçons 5. Ces premiers tronçons 5 sont réalisés dans un matériau ferromagnétique à forte perméabilité magnétique. Chaque premier capteur magnétique 4A est placé dans un entrefer 5A présent entre deux tronçons 5. L'ensemble des premiers tronçons 5 et des premiers capteurs magnétiques 4A forme le premier profil magnétique 55 destiné à entourer un conducteur électrique 3. Les premiers capteurs magnétiques 4A sont disposés dans un premier plan X1Y1 à égale distance de l'axe central Z du conducteur 3. Les premiers capteurs magnétiques 4A observent une répartition angulaire régulière autour dudit axe Z. Ils sont composés de préférence de trois sondes à effet Hall réparties à 120° autour de l'axe Z. Cette répartition spécifique des trois premiers capteurs magnétiques 4A permet, en effectuant une somme vectorielle des premiers signaux de mesure SA issue du groupe des premiers capteurs magnétiques 4A, de ne pas être sensible aux champs magnétiques extérieurs ou voisins.

Trois seconds capteurs magnétiques 4B sont disposés sur au moins un second tronçon 6 à faible perméabilité magnétique et tenant un rôle de support mécanique. Selon cette variante de réalisation de l'invention, les seconds capteurs magnétiques 4B sont disposés dans un second plan X2Y2 à égale distance de l'axe central Z du conducteur 3. Par ailleurs, les seconds capteurs magnétiques 4B observent une répartition angulaire régulière autour de l'axe Z. Ils sont de préférence composés de trois sondes à effet Hall réparties à 120° autour de l'axe Z. Cette répartition spécifique des trois seconds capteurs magnétiques 4B permet, en effectuant une somme vectorielle des seconds signaux de mesure SB issue du groupe des trois seconds capteurs magnétiques 4B, de ne pas être sensible aux champs magnétiques extérieurs ou voisins.

Comme représenté sur la figure 5, l'unité de traitement 7 du dispositif de mesure de courant 1 comprend de préférence des moyens de sommation 15. Lesdits moyens effectuent une première somme ΣSA des premiers signaux de mesure SA des premiers capteurs magnétiques 4A et une seconde somme ΣSB des seconds signaux de mesure SB des seconds capteurs magnétiques 4B.

Selon ce mode de réalisation, les moyens de comparaison 14 de l'unité de traitement 7 peuvent effectuer la comparaison d'une quatrième consigne Q11 avec la première somme ΣSA des premiers signaux SA et la comparaison d'une cinquième consigne Q22 avec la seconde somme ΣSB des seconds signaux SB. En outre, l'unité de traitement 7 peut effectuer la comparaison d'une sixième consigne Q33 avec le rapport ΣSA/ΣSB entre la première somme ΣSA des premiers signaux de mesure SA et la seconde somme ΣSB des seconds signaux de mesure SB.

Selon une première variante de réalisation, l'entrefer 5A dans lequel est placé chaque capteur magnétique 4A, comporte un shunt magnétique.

Selon une seconde variante de réalisation, les sondes à effet Hall de premiers et seconds capteurs magnétiques 4A, 4B sont programmables. Ainsi en fonction du calibre du dispositif de mesure 1, le gain de chaque sonde à effet hall peut être ajusté en conséquence. Un premier coefficient pondérateur peut être appliqué à chaque signal de mesure SA,SB, émis par chaque capteur magnétique. Le même dispositif de mesure peut ainsi être utilisé pour différents calibres de mesure.

Selon une autre variante de réalisation, les seconds et les premiers capteurs magnétiques 4A, 4B sont placés à des distances différentes de l'axe central Z du conducteur 3.

Un second coefficient pondérateur peut permettre de corriger des erreurs de mesure dues au défaut de positionnement de chaque capteur magnétique par rapport au conducteur 3. En effet, avant utilisation, chaque dispositif de mesure 1 peut être étalonné dans des conditions réelles de fonctionnement. Compte tenu de la répartition géométrique et de la distance séparant chaque sonde du conducteur, toutes les sondes doivent théoriquement fournir un même signal. Cependant, compte tenu des légers défauts de centrage et d'orientation du conducteur par rapport aux sondes et compte tenu des possibles perturbations dues à l'environnement, il est observé des variations d'intensité de signal de mesure de chaque sonde. Le second coefficient pondérateur permet alors de compenser ces disparités afin d'égaler les signaux de mesure fournis par les sondes.

Le dispositif de mesure de courant 1 selon les différents modes de réalisation de l'invention, est particulièrement destiné à être combiné à une carte électronique de conversion 21.

La carte de conversion 21 est contenue dans un déclencheur électronique 20 destiné à commander l'ouverture d'un dispositif de coupure tel qu'un disjoncteur 40. La carte de conversion 21 est connectée aux moyens de déclenchement 22 du déclencheur électronique 20.

La carte de conversion 21 est destinée à transformer le signal de sortie S continu issu des moyens de traitement 7 du dispositif de mesure 1 et fournir un signal alternatif de commande aux moyens de déclenchement 22 du déclencheur électrique 20.

La valeur efficace continue du champ proportionnel au courant continu envoyé par les moyens de traitement 7 du dispositif de mesure 1, est transformée en signal alternatif 50Hz de même valeur efficace.

Le choix de la gamme de mesure long retard ou court retard est réalisé par cette carte de conversion 21 en fonction de la linéarité des signaux. La carte de conversion 21 est identique quel que soit le calibre du disjoncteur 40.

Le présent déclencheur électronique 20 est particulièrement destiné aux disjoncteurs électriques. Si le déclencheur électronique 20 reçoit du dispositif de mesure de courant 1, une information de défaut présent sur au moins une des lignes ou des conducteurs électriques 25, un ordre de commande d'ouverture des contacts 30 peut être émis par les moyens de déclenchement 22. Ledit ordre est envoyé au relais de commande 31 qui ouvre les contacts 30 par l'intermédiaire d'un mécanisme de commande 32. Lesdits contacts 30 sont placés en série avec des lignes ou des conducteurs électriques 25.

Des premiers moyens d'alimentation en tension continue 50A peuvent être connectés au déclencheur électronique 20. Ces premiers moyens d'alimentation en tension continue 50A, de préférence internes au dispositif de coupure, sont reliés directement à au moins une ligne ou un conducteur électrique 25.

Selon une première variante de réalisation, des seconds moyens d'alimentation électrique 50B auxiliaires peuvent aussi être connectés au déclencheur électronique 20. Ces seconds moyens d'alimentation électrique, externes au disjoncteur, sont destinés à alimenter le déclencheur électronique 20 lors d'un défaut de fonctionnement des premiers moyens d'alimentation 50A notamment en cas de court-circuit sur les lignes électriques 25. En cas de court-circuit important, la tension du réseau peut alors baisser et provoquer une diminution de la tension fournie par les premiers moyens d'alimentation 50A en tension continue. Une telle diminution peut provoquer un mauvais fonctionnement des moyens de déclenchements 22 ne pouvant plus alimenter le relais de commande 31 pour ouvrir le disjoncteur 40.

Selon une seconde variante de réalisation, le disjoncteur 40 comporte un déclencheur électromagnétique 50C qui permet d'assurer une auto-protection lorsque le disjoncteur 40 n'est pas alimenté via une alimentation interne 50A ou une alimentation auxiliaire externe 50B. Ce type de déclencheur assure une protection instantanée en présence de défauts dus à un court-circuit. Selon cette variante de réalisation, le déclencheur électromagnétique 50C comporte un circuit magnétique ayant une partie mobile et une partie fixe. Le circuit magnétique entoure la ligne ou le conducteur électrique 25 formant le circuit primaire d'un transformateur. Un enroulement secondaire est bobiné sur une partie du circuit magnétique. Cet enroulement secondaire est directement connecté au relais de commande 31.

La partie mobile a une première position ouverte ouvrant le circuit magnétique avec un entrefer de distance élevée. Par tailleurs, la partie mobile a une seconde position fermée fermant le circuit magnétique avec un entrefer petit ou nul. Ladite partie mobile passant de la première position ouverte à la seconde position fermée lorsqu'un courant primaire circulant dans une ligne ou un conducteur électrique 25 dépasse une valeur prédéterminée.

Une variation importante du courant primaire s'accompagne d'une variation importante du flux créé dans le circuit magnétique. Cette variation du flux induit un courant secondaire dans l'enroulement secondaire. Le courant secondaire alimente le relais de commande 31 du disjoncteur 40 pour provoquer l'ouverture des contacts 32. Un tel déclenchement sur court-circuit ne se fait qu'à partir d'une valeur élevée de la dérivée du courant primaire. Ce type de déclencheur est décrit dans le brevet européen de la demanderesse ayant pour numéro de publication EP0841670. La description dudit brevet est citée ici à titre de référence.

Le déclencheur électromagnétique 50C est de préférence inhibé en cas de présence d'une tension interne ou d'une tension externe auxiliaire. Un interrupteur 24 commandé par le déclencheur électronique 20 permet d'interrompre la liaison électrique entre l'enroulement secondaire du déclencheur électromagnétique 50C et le relais de commande 31.

## Revendications

1. Dispositif de mesure de courant continu (1 ) comportant :
- au moins un premier capteur magnétique (4A) et au moins un second capteur magnétique (4B), lesdits capteurs magnétiques étant sensibles à un champ magnétique généré par un courant électrique (I) circulant dans un conducteur (3),
- une unité de traitement (7) connectée aux capteurs magnétiques (4A, 4B) et destinée à générer un signal de sortie (S) dépendant des signaux de mesure fournis par les capteurs magnétiques (4A, 4B) et représentatif dudit courant électrique circulant (I) dans le conducteur (3),
**caractérisé en ce que** l'unité de traitement (7) comporte :
- une première entrée (11) recevant des premiers signaux de mesure (SA) dudit au moins un premier capteur magnétique (4A) intégré dans un premier profil (55) destiné à entourer le conducteur électrique (3) et comprenant au moins un tronçon (5) en matériau ferromagnétique à forte perméabilité magnétique ;
- une seconde entrée (12) recevant des seconds signaux de mesure (SB) dudit au moins un second capteur magnétique (4B) disposé sur au moins un tronçon (6) à faible perméabilité magnétique pour former un second profil destiné à entourer le conducteur électrique (3),
- des moyens de sélection (13) fournissant le signal de sortie (S) dépendant, pour des faibles courants électriques (I), des premiers signaux de mesure (SA), et dépendant, pour des forts courants électriques (I), des seconds signaux de mesure (SB).

2. Dispositif de mesure de courant continu selon la revendication 1 **caractérisé en ce que** l'unité de traitement (7) comporte des moyens de comparaison (14) comparant au moins un premier signal de mesure (SA) avec une première consigne (Q1), le signal de sortie (S) étant dépendant des premiers signaux de mesure (SA) si les premiers signaux de mesure (SA) sont inférieurs à ladite première consigne.

3. Dispositif de mesure de courant continu selon la revendication 1 ou 2 **caractérisé en ce que** l'unité de traitement (7) comporte des moyens de comparaison (14) comparant au moins un second signal de mesure (SB) avec une seconde consigne (Q2), le signal de sortie (S) étant dépendant de premiers signaux de mesure (SA) si les seconds signaux de mesure (SB) sont inférieurs à ladite seconde consigne.

4. Dispositif de mesure de courant continu selon l'une des revendications 1 à 3 **caractérisé en ce que** l'unité de traitement (7) comporte des moyens de comparaison (14) comparant un rapport (SA/SB) entre le premier signal de mesure (SA) et le second signal de mesure (SB) avec une troisième consigne (Q3), le signal de sortie (S) étant dépendant du premier signal de mesure (SA) si ledit rapport (SA/SB) est supérieur ou égal à la troisième consigne (Q3), la troisième consigne (Q3) étant égale à un rapport théorique entre les premier et second signaux de mesure (SA) et (SB) pour de faibles courants électriques (I).

5. Dispositif de mesure de courant selon la revendication 2 **caractérisé en ce que** la première consigne (Q1) est inférieure au seuil de saturation Qs, un premier courant électrique (11) donnant naissance à un premier signal de mesure (SA) égal à la première consigne (Q1) est inférieur à la valeur d'un courant de saturation (Is).

6. Dispositif de mesure de courant selon l'une quelconque des revendications précédentes **caractérisé en ce qu'**il comporte :
- au moins trois premiers capteurs magnétiques (4A) reliés entre eux par des premiers tronçons (5) en matériau ferromagnétique à forte perméabilité magnétique pour former le premier profil magnétique (55) destiné à entourer le conducteur électrique (3),
- au moins trois seconds capteurs magnétiques (4B) disposés sur ledit au moins un second tronçon (6) à faible perméabilité magnétique pour former un second profil magnétique destiné à entourer le conducteur électrique (3),
- des moyens de sommation (15) effectuant une première somme (ΣSA) des premiers signaux de mesure (SA) et une seconde somme (ΣSB) des seconds signaux de mesure (SB).

7. Dispositif de mesure de courant selon la revendication 6 **caractérisé en ce** le signal de sortie (S) est dépendant des premiers signaux de mesure (SA), si la première somme (ΣSA) des premiers signaux de mesure (SA) est inférieure à une quatrième consigne (Q11).

8. Dispositif de mesure de courant selon la revendication 6 ou 7 **caractérisé en ce** le signal de sortie (S) est dépendant des premiers signaux de mesure (SA), si la seconde somme (ΣSB) des seconds signaux de mesure (SB) est inférieure à une cinquième consigne (Q22)

9. Dispositif de mesure de courant selon l'une des revendications 6 à 8 **caractérisé en ce** le signal de sortie (S) est dépendant des premiers signaux de mesure (SA), si le rapport (ΣSA/ΣSB) mesuré entre la première somme (ΣSA) et la seconde somme (ΣSB) est supérieur ou égal à une sixième consigne (Q33), la sixième consigne (Q33) est égale à un rapport théorique entre les première et seconde sommes (ΣSA, ΣSB) des premiers et seconds signaux de mesure (SA) et (SB) pour de faibles courants électriques (I).

10. Dispositif de mesure de courant selon l'une quelconque des revendications précédentes **caractérisé en ce que** les premiers capteurs magnétiques (4A) sont disposés dans un premier plan (X1Y1) à égale distance de l'axe central (Z) du conducteur (3) et que les seconds capteurs magnétiques (4B) sont disposés dans un second plan (X2Y2) à égale distance de l'axe central (Z) du conducteur (3).

11. Dispositif de mesure de courant selon la revendication 10 **caractérisé en ce** les premiers capteurs magnétiques (4A) sont composés de trois sondes à effet Hall réparties à 120° autour de l'axe central (Z) et que les seconds capteurs magnétiques (4B) sont composés de trois sondes à effet Hall réparties à 120° autour de l'axe central (Z).

12. Dispositif de mesure de courant selon l'une quelconque des revendications précédentes, **caractérisé en ce que** les premiers capteurs magnétiques (4A) et les seconds capteurs magnétiques (4B) sont placés à égale distance de l'axe central (Z) du conducteur (3).

13. Ensemble électrotechnique comprenant un dispositif de mesure de courant (1) selon les revendications précédentes combiné à une carte électronique de conversion (21) d'un déclencheur électronique (20), **caractérisé en ce que** la carte de conversion (21) reliée à des moyens de déclenchement (22) transforme le signal de sortie (S) issu des moyens de traitement (7) du dispositif de mesure (1) et fournit un signal alternatif de commande aux moyens de déclenchement (22) du déclencheur électrique (20), lesdits moyens de déclenchement (22) envoyant des ordres de déclenchement.

14. Dispositif de coupure (40) comprenant un ensemble électrotechnique selon la revendication 13, **caractérisé en ce qu'**il comporte un mécanisme de d'ouverture (32) de contacts électriques (30) et un relais de commande (31) relié au déclencheur électronique (20), ledit relais de commande (31) recevant des ordres déclenchement du déclencheur électronique (20) et/ou d'un déclencheur électromagnétique (50C).

15. Dispositif de coupure (40) selon la revendication 14, **caractérisé en ce que** le déclencheur électromagnétique (50C) comporte :
• un circuit magnétique entourant une ligne ou conducteur électrique (25) formant le circuit primaire d'un transformateur,
• un enroulement secondaire bobiné sur une partie du circuit magnétique étant directement connecté au relais de commande (31).

## Claims

1. A DC current measuring device (1) comprising:
- at least a first magnetic sensor (4A) and at least a second magnetic sensor (4B), said magnetic sensors being sensitive to a magnetic field generated by an electric current (I) flowing in a conductor (3),
- a processing unit (7) connected to the magnetic sensors (4A, 4B) and designed to generate an output signal (S) dependent on the measurement signals supplied by the magnetic sensors (4A, 4B) and representative of said electric current (I) flowing in the conductor (3),
**characterized in that** the processing unit (7) comprises:
- a first input (11) receiving first measurement signals (SA) from said at least a first magnetic sensor (4A) integrated in a first profile (55) designed to surround the electric conductor (3) and comprising at least a section (5) made from ferromagnetic material of high magnetic permeability,
- a second input (12) receiving second measurement signals (SB) from said at least a second magnetic sensor (4B) arranged on at least a section (6) of low magnetic permeability to form a second profile designed to surround the electric conductor (3),
- selection means (13) supplying the output signal (S) dependent on the first measurement signals (SA) for weak electric currents (I), and dependent on the second measurement signals (SB) for strong electric currents (I).

2. The DC current measuring device according to claim 1 **characterized in that** the processing unit (7) comprises comparison means (14) comparing at least a first measurement signal (SA) with a first setpoint (Q1), the output signal (S) being dependent on the first measurement signals (SA) if the first measurement signals (SA) are lower than said first setpoint.

3. The DC current measuring device according to claim 1 or 2 **characterized in that** the processing unit (7) comprises comparison means (14) comparing at least a second measurement signal (SB) with a second setpoint (Q2), the output signal (S) being dependent on the first measurement signals (SA) if the second measurement signals (SB) are lower than said second setpoint.

4. The DC current measuring device according to one of claims 1 to 3 **characterized in that** the processing unit (7) comprises comparison means (14) comparing a ratio (SA/SB) between the first measurement signal (SA) and the second measurement signal (SB) with a third setpoint (Q3), the output signal (S) being dependent on the first measurement signal (SA) if said ratio (SA/SB) is greater than or equal to the third setpoint (Q3), the third setpoint (Q3) being equal to a theoretical ratio between the first and second measurement signals (SA) and (SB) for weak electric currents (I).

5. The current measuring device according to claim 2 **characterized in that** the first setpoint (Q1) is lower than the saturation threshold (Qs), a first electric current (11) giving rise to a first measurement signal (SA) equal to the first setpoint (Q1) is lower than the value of a saturation current (Is).

6. The current measuring device according to any one of the foregoing claims **characterized in that** it comprises:
- at least three first magnetic sensors (4A) connected to one another by first sections (5) of high magnetic permeability to form the first magnetic profile (55) designed to surround the electric conductor (3),
- at least three second magnetic sensors (4B) arranged on at least a second section (6) of low magnetic permeability to form a second magnetic profile designed to surround the electric conductor (3),
- summing means (15) making a first sum (ΣSA) of the first measurement signals (SA) and a second sum (ΣSB) of the second measurement signals (SB).

7. The current measuring device according to claim 6 **characterized in that** the output signal (S) is dependent on the first measurement signals (SA) if the first sum (ΣSA) of the first measurement signals (SA) is lower than a fourth setpoint (Q11).

8. The current measuring device according to claim 6 or 7 **characterized in that** the output signal (S) is dependent on the first measurement signals (SA) if the second sum (ΣSB) of the second measurement signals (SB) is lower than a fifth setpoint (Q22).

9. The current measuring device according to one of claims 6 to 8 **characterized in that** the output signal (S) is dependent on the first measurement signals (SA) if the ratio (ΣSA/ΣSB) measured between the first sum (ΣSA) and the second sum (ΣSB) is greater than or equal to a sixth setpoint (Q33), the sixth setpoint (Q33) being equal to a theoretical ratio between the first and second sums (ΣSA, ΣSB) of the first and second measurement signals (SA) and (SB) for weak electric currents (I).

10. The current measuring device according to any one of the foregoing claims **characterized in that** the first magnetic sensors (4A) are arranged in a first plane (X1Y1) at equal distance from the central axis (Z) of the conductor (3) and that the second magnetic sensors (4B) are arranged in a second plane (X2Y2) at equal distance from the central axis (Z) of the conductor (3).

11. The current measuring device according to claim 10 **characterized in that** the first magnetic sensors (4A) are composed of three Hall effect sensors arranged 120° from one another around the central axis Z and that the second magnetic sensors (4B) are composed of three Hall effect sensors arranged 120° from one another around the central axis Z.

12. The current measuring device according to any one of the foregoing claims **characterized in that** the first magnetic sensors (4A) and second magnetic sensors (4B) are placed at equal distance from the central axis Z of the conductor (3).

13. An electro-technical assembly comprising a current measuring device (1) according to the foregoing claims combined with an electronic conversion card (21) of an electronic trip unit (20), **characterized in that** the conversion card (21) connected to trip means (22) transforms the output signal (S) originating from the processing means (7) of the measuring device (1) and provides an AC command signal to the trip means (22) of the electronic trip unit (20), said trip means (22) sending tripping orders.

14. A switchgear device (40) comprising an electrotechnical assembly according to claim 13, **characterized in that** it comprises an opening mechanism (32) for opening electric contacts (30) and a control relay (31) connected to the electronic trip unit (20), said control relay (31) receiving tripping orders from the electronic trip unit (20) and/or from an electromagnetic trip unit (50C).

15. The switchgear unit (40) according to claim 14 **characterized in that** the electromagnetic trip unit (50C) comprises:
- a magnetic circuit surrounding an electric line or conductor (25) forming the primary circuit of a transformer,
- a secondary winding coiled on a part of the magnetic circuit being directly connected to the control relay (31).

## Patentansprüche

1. Gleichstrom-Messeinrichtung (1) mit
- mindestens einem ersten Magnetfeldsensor (4A) und mindestens einem zweiten Magnetfeldsensor (4B), welche Magnetfeldsensoren in der Lage sind, ein Magnetfeld erfassen, das von einem über einen Leiter (3) fließenden elektrischen Strom (I) erzeugt wird,
- und einer an die Magnetfeldsensoren (4A, 4B) angeschlossenen Verarbeitungsschaltung (7), die dazu dient, ein Ausgangssignal (S) zu erzeugen, das von den durch die Magnetfeldsensoren (4A, 46) gelieferten Messsignalen abhängt und den über den Leiter (3) fließenden genannten Strom (I) abbildet,
**dadurch gekennzeichnet, dass** die Verarbeitungsschaltung (7)
- einen ersten Eingang (11), der mit ersten Messsignalen (SA) des genannten, mindestens einfach vorhandenen ersten Magnetfeldsensors (4A) beaufschlagt wird, welcher Sensor in ein erstes Profil (55) integriert ist, das dazu dient, um den Leiter (3) geführt zu werden, und mindestens einen Abschnitt (5) aus einem ferromagnetischen Werkstoff mit hoher magnetischer Permeabilität umfasst,
- einen zweiten Eingang (12), der mit zweiten Messsignalen (SB) des genannten, mindestens einfach vorhandenen zweiten Magnetfeldsensors (4B) beaufschlagt wird, welcher Sensor auf mindestens einem Abschnitt (6) mit geringer magnetischer Permeabilität angeordnet ist, der ein zweites Profil bildet, das dazu dient, um den elektrischen Leiter (3) geführt zu werden,
- sowie Auswahlmittel (13) umfasst, die das Ausgangssignal (S) liefern, welches bei kleinen elektrischen Strömen (I) von den ersten Messsignalen (SA) und bei hohen elektrischen Strömen (I) von den zweiten Messsignalen (SB) abhängt.

2. Gleichstrom-Messeinrichtung nach Anspruch 1, **dadurch gekennzeichnet, dass** die Verarbeitungsschaltung (7) Vergleichsmittel (14) umfasst, die mindestens ein erstes Messsignal (SA) mit einem ersten Sollwert (Q1) vergleichen, wobei das Ausgangssignal (S) von den ersten Messsignalen (SA) abhängt, wenn die ersten Messsignale (SA) unter dem genannten ersten Sollwert liegen.

3. Gleichstrom-Messeinrichtung nach Anspruch 1 oder 2, **dadurch gekennzeichnet, dass** die Verarbeitungsschaltung (7) Vergleichsmittel (14) umfasst, die mindestens ein zweites Messsignal (SB) mit einem zweiten Sollwert (Q2) vergleichen, wobei das Ausgangssignal (S) von den ersten Messsignalen (SA) abhängt, wenn die zweiten Messsignale (SB) unter dem genannten zweiten Sollwert liegen.

4. Gleichstrom-Messeinrichtung nach einem der Ansprüche 1 bis 3, **dadurch gekennzeichnet, dass** die Verarbeitungsschaltung (7) Vergleichsmittel (14) umfasst, die ein Verhältnis (SA/SB) zwischen dem ersten Messsignal (SA) und dem zweiten Messsignal (SB) mit einem dritten Sollwert (Q3) vergleichen, wobei das Ausgangssignal (S) vom ersten Messsignal (SA) abhängt, wenn das genannte Verhältnis (SA/SB) größer oder gleich dem dritten Sollwert (Q3) ist, und der dritte Sollwert (Q3) einem theoretischen Verhältnis zwischen ersten Messsignal (SA) und dem zweiten Messsignal (SB) bei kleinen elektrischen Strömen (I) entspricht.

5. Gleichstrom-Messeinrichtung nach Anspruch 2, **dadurch gekennzeichnet, dass** der erste Sollwert (Q1) unter dem Sättigungs-Schwellwert Qs liegt, wobei ein erster elektrischer Strom (11), der ein dem ersten Sollwert (Q1) entsprechendes erstes Messsignal (SA) zur Folge hat, unter dem Wert eines Sättigungsstroms (Is) liegt.

6. Strommesseinrichtung nach irgendeinem der vorhergehenden Ansprüche,
**dadurch gekennzeichnet, dass** sie darüber hinaus
- mindestens drei erste Magnetfeldsensoren (4A), die über erste Abschnitte (5) aus einem ferromagnetischen Werkstoff mit hoher magnetischer Permeabilität miteinander verbunden sind, welche Abschnitte das um den elektrischen Leiter (3) zu führende erste Magnetprofil (55) bilden,
- mindestens drei zweite Magnetfeldsensoren (4B), die auf dem genannten, mindestens einfach vorhandenen zweiten Abschnitt (6) mit niedriger magnetischer Permeabilität angeordnet sind, der ein um den elektrischen Leiter (3) zu führendes zweites Magnetprofil bildet,
- sowie Addiermittel (15) umfasst, die eine erste Summe (ΣSA) der ersten Messsignale (SA) und eine zweite Summe (ΣSB) der zweiten Messsignale (SB) bilden.

7. Strommesseinrichtung nach Anspruch 6, **dadurch gekennzeichnet, dass** das Ausgangssignal (S) von den ersten Messsignalen (SA) abhängt, wenn die erste Summe (ΣSA) der ersten Messsignale (SA) unter einem vierten Sollwert (Q11) liegt.

8. Strommesseinrichtung nach Anspruch 6 oder 7, **dadurch gekennzeichnet, dass** das Ausgangssignal (S) von den ersten Messsignalen (SA) abhängt, wenn die zweite Summe (ΣSB) der zweiten Messsignale (SB) unter einem fünften Sollwert (Q22) liegt.

9. Strommesseinrichtung nach einem der Ansprüche 6 bis 8, **dadurch gekennzeichnet, dass** das Ausgangssignal (S) von den ersten Messsignalen (SA) abhängt, wenn das gemessene Verhältnis (ΣSA/ΣSB) zwischen der ersten Summe (ΣSA) und der zweiten Summe (ΣSB) größer oder gleich einem sechsten Sollwert (Q33) ist, wobei der sechste Sollwert (Q33) einem theoretischen Verhältnis zwischen der ersten und der zweiten Summe (ΣSA, ΣSB) der ersten Messsignale (SA) und der zweiten Messsignale (SB) bei kleinen elektrischen Strömen (I) entspricht.

10. Strommesseinrichtung nach irgendeinem der vorhergehenden Ansprüche, **dadurch gekennzeichnet, dass** die ersten Magnetfeldsensoren (4A) in einer ersten Ebene (X1Y1), in gleichem Abstand zur Mittelachse (Z) des Leiters (3) angeordnet sind und dass die zweiten Magnetfeldsensoren (4B) in einer zweiten Ebene (X2Y2), in gleichem Abstand zur Mittelachse (Z) des Leiters (3) angeordnet sind.

11. Strommesseinrichtung nach Anspruch 10, **dadurch gekennzeichnet, dass** die ersten Magnetfeldsensoren (4A) aus drei Hall-Sensoren bestehen, die im Abstand von jeweils 120° um die Mittelachse (Z) herum angeordnet sind, und dass die zweiten Magnetfeldsensoren (4B) aus drei Hall-Sensoren bestehen, die im Abstand von jeweils 120° um die Mittelachse (Z) herum angeordnet sind.

12. Strommesseinrichtung nach irgendeinem der vorhergehenden Ansprüche, **dadurch gekennzeichnet, dass** die ersten Magnetfeldsensoren (4A) und die zweiten Magnetfeldsensoren (4B) in gleichem Abstand von der Mittelachse (Z) des Leiters (3) angeordnet sind.

13. Elektrische Anordnung mit einer Strommesseinrichtung (1 ) nach den vorhergehenden Ansprüchen in Kombination mit einer elektronischen Umrichterkarte (21) eines elektronischen Auslösers (20), **dadurch gekennzeichnet, dass** die mit den Auslösemitteln (20) verbundene Umrichterkarte (21) das von der Verarbeitungsschaltung (7) der Messeinrichtung (1) gelieferte Ausgangssignal (S) umrichtet und ein Wechsel-Steuersignal an die Auslösemittel (22) des elektronischen Auslösers (20) liefert, wobei die genannten Auslösemittel (22) Auslösebefehle aussenden.

14. Schaltgerät (40) mit einer elektrischen Anordnung nach Anspruch 13, **dadurch gekennzeichnet, dass** es einen Abschaltmechanismus (32) zur Abschaltung von elektrischen Kontakten (30) sowie ein mit dem elektronischen Auslöser verbundenes Steuerrelais (31) umfasst, welches Steuerrelais (31) Auslösebefehle vom elektronischen Auslöser (20) und/oder von einem elektromagnetischen Auslöser (50C) empfängt.

15. Elektrisches Schaltgerät (40) nach Anspruch 14, **dadurch gekennzeichnet, dass** der elektromagnetische Auslöser (50C)
• einen Magnetkreis (16), der um eine Leitung bzw. einen elektrischen Leiter (25) geführt ist, die den Primärleiter eines Stromwandlers bilden,
• und eine um einen Teil des Magnetkreises geführte Sekundärwicklung umfasst, die direkt mit dem Steuerrelais (31) verbunden ist.
